# EUROPEAN PATENT APPLICATION

(11) **EP 1 455 229 A1**
(43) Date of publication of application: **08.09.2004**
(21) Application number: 04250947.1
(22) Date of filing: 23.02.2004
(51) Int. Cl.: G03F 7/075

(54) **Silicon-containing fluorinated polymers and photoresists comprising same**

(30) Priority: 23.02.2003 US 449787 P
(71) Applicant: Rohm and Haas Electronic Materials, L.L.C., Marlborough, Massachusetts 01752 (US)
(72) Inventor: Barclay, George G., Jefferson, Massachusetts 01522 (US); Kanagasabapathy, Subbareddy, Worcester, Massachusetts 01605 (US); Pohlers, Gerhard, Newton, Massachusetts 02458 (US)
(74) Representative: Kent, Venetia Katherine

(57) **Abstract**

Photoimageable compositions are provided that contain Si-polymers that have a specified ratio of fluorine atoms to Si atoms. Preferred photoresists of the invention can exhibit enhanced resistance to plasma etchants.

## Description

The present application claims the benefit of U.S. provisional application number 60/449,787, filed February 23,2003, which is incorporated herein by reference in its entirety.

### BACKGROUND

### 1. Field of the Invention.

The present invention relates to photoimageable compositions that contain Si-polymers that have a specified ratio of fluorine atoms to Si atoms. Preferred photoresists of the invention can exhibit enhanced resistance to plasma etchants.

### 2. Background.

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable agents of the photoresist composition. Consequently, the exposed coating portions are rendered less soluble in a developer solution than unexposed portions. For positive-acting photoresists, exposed portions are rendered more soluble in a developer solution while areas not exposed remain comparatively less developer soluble. In general, photoresist compositions include at least a resin binder component and a photoactive agent.

The increasing density of integrated circuits has created a need for higher resolution patterning capabilities. One method of improving resolution involves using a shorter wavelength light during pattern formation. Shorter wavelengths of approximately 200 to 280 nm may be obtained by using a deep UV ("DUV") source such as a mercury/xenon ("Hg/Xe") lamp with appropriate filters. Additionally, KrF (248 nm) or ArF (193 nm) excimer lasers may be used as exposure sources.

In addition to using shorter wavelengths during exposure, it is also desirable to use a thinner layer of resist. However, the major drawback of using a thin layer of resist is that the variation of resist thickness over a diffusion step on a substrate and into an etched pattern increases as the pattern size becomes smaller. This variation means that the dimensions of any pattern being imaged in the resist will vary as the step geometry is traversed. Therefore, in a single layer resist system, the lack of dimensional control on the wafer can create different line widths throughout the resist which reduces the quality of the electronic package.

To attempt to improve dimensional control, bilayer (or bilevel or multilevel) resist systems have been utilized. In a typical bilevel system, a bottom resist is first applied to a substrate to planarize wafer topography. The bottom resist is cured and a second thinner imaging top resist is then applied over the bottom resist. The top resist is then soft baked, and patterned (or imaged) using conventional resist exposure and development, followed by etch transfer of the top pattern through the bottom resist using the top resist pattern as an etch mask. Positive resists are commonly used in bilayer applications and are typically based on novolac resins, which are condensation polymers of phenols or substituted phenols and formaldehyde. See, generally, Sugiyama et al., *Positive Excimer Laser Resists Prepared with Aliphatic Diazoketones,* Soc. Plastics Eng., Conference Proceedings, pages 51-60 (Nov. 1988); and U.S. Patents 4,745,169; 5,338,818; 5,619,396; 5,731,126; 6,296,985; and 6,340,734. Additional silicon photoresists are disclosed in WO 02/091083; U.S. Patent Publication 2002/0090572; and U.S. Patent 5,378,585.

A problem associated with the thin-layer bi-layer resist systems is relatively poor resistance to plasma etchants, which can limit the use of the resists in many applications. See US 2003/0207205. See also U.S. Patent 6,593,058.

It would be desirable to have new photoresists that could provide small images of high resolution. It would be particularly desirable to have new photoresists that could be effectively imaged with short wavelength radiation, including sub-300 nm and sub-200 nm radiation such as 193 nm and 157 nm. It would be especially desirable to have such photoresists that could exhibit good resistance to plasma etchants.

### SUMMARY OF THE INVENTION

We have now provide new fluorinated Si-polymers and photoresists that comprise such polymers.

More particularly, fluorinated Si-polymers are now provided which are characterized in part as having a specified range or limit of fluorine atoms to silicon atoms in the polymer. In particular, preferred polymers of the invention will have a ratio (molar ratio or atom number ratio) ratio of fluorine atoms to Si atoms of about 3 or less, more preferably a lower ratio of F:Si atoms, such as an F:Si ratio of about 2.5, 2.4, 2.1 or 2 or less.

We have found that photoresists that contain such polymers can exhibit enhanced resistance to plasma etchants. See, for instance, the results of the Examples 7 and 8 which follow. Thus, photoresists of the invention will be useful in many, significant applications.

A number of strategies may be employed either alternatively or in combination to provide a desired F:Si molar ratio.

A preferred approach is to modulate the content or molar amount of distinct repeat units within a polymer in order to achieve a desired F: Si atom number ratio. For example, a polymer the relative amounts of repeat units that have differing fluorine content can be modulated to achieve a desired total F:Si atom ratio for the entire polymer. More particularly, for instance, a polymer unit that has a norbornyl substituted hexafluoropropylalcohol group can be used in a reduced amount relative to one or more other polymer units that have fewer or no fluorine atoms. This is exemplified by the polymers of Example 7 below, where reducing the amount of a norbornyl substituted hexafluoropropylalcohol Si unit in a copolymer provided lower F:Si atom ratios.

A related approach is to introduce a further distinct repeat unit into a polymer in order to achieve a desired F:Si atom number ratio, where that added unit has a lower F:Si atom ratio than one or more of the other units. For instance, addition of a repeat unit to a polymer that has only a single fluorine atom, or no fluorine atoms, where one or more other units have a higher F:Si content (e.g. a norbornyl substituted hexafluoropropylalcohol Si unit), then that addition would provide the higher order polymer a reduced F:Si atom ratio.

A yet further approach is selection of an appropriate polymer repeat unit in order to achieve a desired F:Si atom number ratio. For instance, an aqueous-solubilizing unit that has a relatively reduced number of fluorine atoms can be employed to reduce the overall F:Si atom content of the polymer. More particularly, a fluorinated sulfonamide group (e.g. -NHSO₂CF₃, -NHSO₂CHF₂, -NHSO₂CH₂F and the like) can be used in place of hexafluoropropylalcohol to provide a lower total F:Si atom ratio for the polymer.

Polymers of the invention may have a variety of fluorine substitution, e.g. comprise carbons having one or more fluorine atoms as part of the polymer backbone and/or as pendant groups. For instance, -CF₃ moieties are preferred polymer substituents. Tetrafluoroethylene or other fluorinated olefin also may be polymerized to provide polymer fluorine substitution.

Preferred polymers of the invention will have a high Si content, e.g. at least about 12, 15,16, 17, 18, 19 or 20 mole percent of total polymer being Si. Typically, not more than about 80, 70, 60, 40 or 30 mole percent of the polymer will be Si.

Preferred polymers also may have narrow polydispersity values (i.e. Mw/Mn), such as about 2 or less, more preferably about 1.5 or less, about 1.4 or less, about 1.3 or less, about 1.2 or less, or about 1.1 or less.

For short-wavelength imaging, particularly sub-nm 200 imaging, preferably the polymer has low aromatic content to provide enhanced transparency. For instance, preferred polymers for such short wavelength imaging will be substantially free of aromatic groups, e.g. less than about 5, 4, 3, 2, 1 or 0.5 mole percent aromatic groups based on total polymer units. Even more preferred will be polymers that are completely free of aromatic groups.

Preferred polymer units include alicyclic groups that can provide resistance to plasma etchants. Optionally substituted norbornyl, adamantyl, fencyl and isobornyl are preferred alicyclic groups, although other alicyclic moieties having 1 to 4 separate or fused alicyclic rings and from 5 to about 20 ring atoms also will be suitable.

Polymers of the invention also suitably may contain phenolic or other aromatic groups, particularly where the polymer is used in a resist imaged at higher wavelengths such as 248 nm. Such polymers that contain aromatic groups may be provided e.g. by polymerization of a phenyl group substituted with a trichlorosilyl group, trialkoxysilyl, and the like.

Preferred polymers of the invention may contain two, three, four or more distinct repeat units.

In such higher order polymers, a variety of other repeat units may be utilized. For instance, repeat units that contain aromatic or alicyclic groups may be utilized to provide etch resistance. Repeat units that contain a photoacid-labile or fluorinated alcohol may be utilized to provide desired contrast.

Possible type of distinct repeat units can be categorized among the following: 1) aqueous-base solublizing groups; 2) groups with photoacid-labile groups; and 3) so-called "inert" groups, i.e. groups that are free of any hydroxy, carboxy or other aqueous base-solublizing groups or any photoacid-labile groups. A single repeat unit also may provide more than one of the above function, e.g. a single repeat unit have both a base-solubilizing moiety and a photoacid-labile group.

As referred to herein, aqueous-base solubilizing groups are polymer units that can facilitate dissolution of the polymer in aqueous alkaline solutions (photoresist developers). Exemplary preferred aqueous-base solubilizing groups include halogenated alcohols particularly fluorinated alcohols such as hexafluoropropyl alcohol; sulfonamides including substituted sulfonamides such as halide-substituted sulfonamides particularly fluorinated sulfonamides (e.g. -NHSO₂CF₃ as discussed above); carboxylic acids including substituted carboxylic acids such as halogenated carboxylic acids particularly a fluorinated carboxylic acid e.g. a moiety of the formula -CF₂COOH; phenolic groups including ring-substituted phenolic groups; thiol groups; and the like. Preferred polymers of the invention may contain aqueous-base solubilizing groups in an amount of at least about 20 mole percent based on total units of the Si-polymer, more preferably at least about 30, 35, 40, 45 or 50 mole percent of aqueous-base solubilizing groups such as a fluorinated alcohol based on total units of a Si-polymer.

So-called "inert" polymer units are free of photoacid-labile groups and aqueous-solubilizing groups, e.g. groups that are free of photoacid-labile ester or acetal moieties, or hydroxy, carboxy or sulfonic acid moieties. Preferred repeat units of this type include carbocyclic aryl (e.g. phenyl or naphthyl) or alkyl (inclusive of alkylidene and other branched groups and non-aromatic alicyclic groups such as adamantyl, norbornyl, cyclohexyl, isobornyl; etc.) groups that are not substituted with such photoacid-labile or aqueous, alkaline solubilizing moieties, e.g. alkyl, phenyl or naphthyl groups that are either unsubstituted or substituted by one or more halo, unsubstituted alkyl, non-photoacid labile alkoxy, mesyl or other sulfonic esters such as those of the formula C₁₋₈alkylSO₃-and the like.

Typical photoresist compositions of the invention also will contain a photoactive component, e.g. one or more photoacid generator compounds.

Photoresists also will include a mechanism to provide sufficient solubility differentials between exposed and unexposed regions of a coating layer of the resist to enable formation of a relief image upon development.

Chemically-amplified positive-acting photoresists suitably will contain a component that preferably has one or more photoacid-labile deblocking groups, i.e. groups that undergo reaction in the presence of photo generated acid to provide a polar group such as carboxy, hydroxy and the like. Preferred photoacid-labile groups include photoacid-labile esters or acetal groups. Such photoacid-labile group(s) suitably will be substituents of the silicon-containing resin, but the resist also may contain a separate component such as a separate oligomer or polymer that contains such photoacid-labile group(s).

As indicated above, positive photoresists imaged at short wavelengths also may suitably contain fluorinated alcohol groups, i.e. alcohols that have proximate (within one or two carbons from the hydroxy-substituted carbon) fluorine substitution.

Negative-acting resists of the invention typically will contain an agent for crosslinking of one or more of the components of the resist, typically a separate crosslinker component such as an amine-based reagent, e.g. a melamine or benzoguanamine resin. Resins used in negative-acting photoresists preferably contain primary or secondary alcohol moieties.

Photoresists of the invention are preferably employed in multilayer lithography systems. More particularly, preferred uses of resists of the invention include application of a first organic polymer coating on a substrate, e.g. a semiconductor microelectronic wafer, and applying thereover a photoresist of the invention. The organic bottom layer suitably may be non-photoimageable (e.g. not contain a photoacid generator compound) but is thermally crosslinked prior to application of the resist layer. The bottom layer may comprise a phenolic polymer such as a novolac admixed with a thermal acid generator compound and a crosslinker. Use of such a bottom layer can enable application of a very thin top resist layer.

The invention also provides methods for forming relief images, including methods for forming a highly resolved relief image such as a pattern of lines where each line has essentially vertical sidewalls and a line width of about 0.40 microns or less, and even a width of about 0.2, or 0.10 microns or less, such as lines having widths of 80 nm or less. The invention further provides articles of manufacture comprising substrates such as a microelectronic wafer substrate (e.g. a wafer having a diameter of less than 20 or 10 inches), optoelectronic device substrate, waveguide or liquid crystal display substrate or other flat panel display substrate having coated thereon a polymer, photoresist or resist relief image of the invention. The invention also includes methods to produce such articles of manufacture, which comprise use of a photoresist of the invention.

Other aspects of the invention are disclosed infra.

### BRIEF DESCRIPTION OF THE DRAWINGS

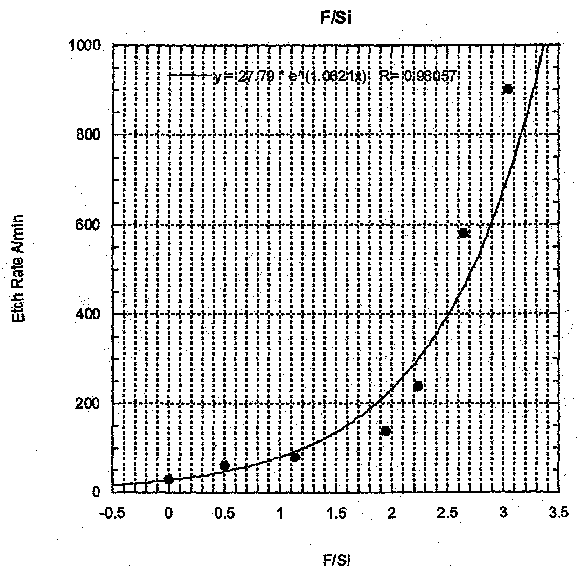

Figure 1 shows graphically improved etch resistance as demonstrated in Example 8 which follows.

### DETAILED DESCRIPTION OF THE INVENTION

As discussed above, we now provide a silicon polymers that have a specified ratio of fluorine atoms to silicon atoms. Preferred polymers of the invention will have a ratio (molar ratio or atom number ratio) ratio of fluorine atoms to Si atoms of about 3 or less. Even lower F:Si ratios will be more preferred, such as an F:Si atom ratio of about 2.9 or less, about 2.8 or less, about 2.7 or less, about 2.6 or less, about 2.5 or less, about 2.4 or less, about 2.3 or less, about 2.2 or less, about 2.1 or less, or about 2 or less.

Such F:Si atom ratios are conveniently confirmed by a variety of analytical techniques particularly NMR. Si content is conveniently determined by ²⁹Si NMR. The feed amount of reagents to form a polymer also will indicate the F:Si ratio of a particular polymer.

It should be understood that the F:Si atom ratios designate herein the total number of F atoms with respect to the total number of Si atoms in the specified polymer. That is, the F atom:Si atom ratios referred to herein are numerical ratios of the total number of the specified F atoms with respect to the total number of Si atoms in a polymer.

Preferred polymers of the invention include those that have minimal aromatic content and are employed in photoresist compositions that are imaged with sub-200 nm radiation such as 193 nm or 157 nm radiation.

Generally preferred polymers of the invention include those that contain Si atoms as a component of the polymer backbone, e.g. Si-O linkages, rather than a polymer that does not contain Si atoms as part of the backbone or substantial part thereof, but rather as pendant groups. More particularly, preferred polymers include those where at least 5 percent of the total number of atoms in the polymer backbone are Si atoms, or where at least about 10, 15, 20, 25, 30, 35, 40, 45, or 50 percent of the total number of atoms in the polymer backbone are Si atoms.

As discussed above, preferred units of polymers of the invention include aqueous-base solubilizing groups, photoacid-labile groups and inert groups, which are exemplified by the following groups 1 through 8; the lines from each Si atom indicate chemical bonds to further hydrogen or non-hydrogen substituents.

### 1. Aqueous-base solubilizing groups:

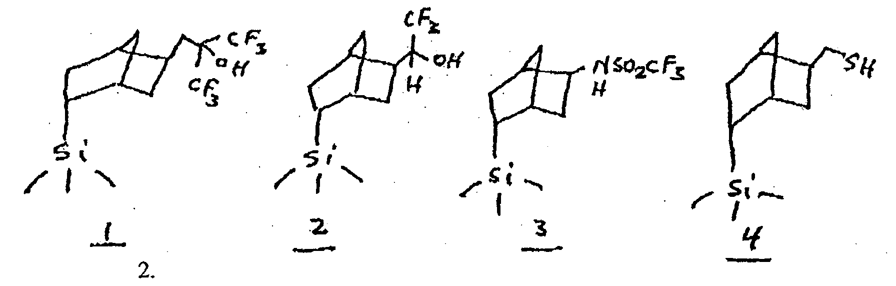

### 2. Photoacid-labile groups:

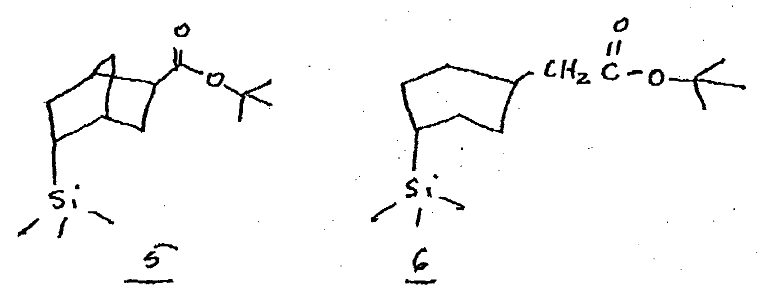

### 3. "Inert" groups (i.e. groups that are free of any hydroxy, carboxy or other aqueous base-solublizing groups or any photoacid-labile groups):

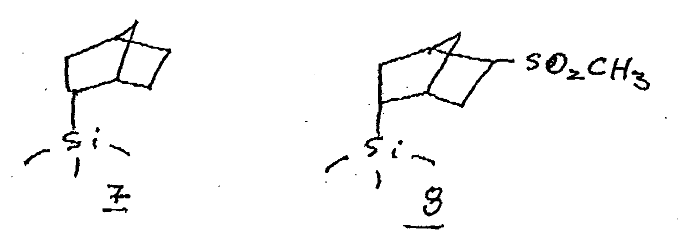

Preferred polymers of the invention include those that are formed from polymerization of a silyl halide or silyl alkoxide, particularly a silyl trihalide or trialkoxy silane such as reagent of the formula R-Si(halide)₃ e.g. R-Si(Cl)₃. The R moiety suitably may be aromatic (e.g. phenyl or naphthyl) or non-aromatic such as an optionally substituted alkyl or alicyclic groups such as norbornyl, adamantyl or the like. Such R groups may be substituted by a photoacid-labile group e.g. acid-labile ester such as t-butyl ester or acetal group, or an acetal group, or by aqueous base-solubilizing groups such as a fluorinated alcohol, sulfonamide, thiol, or the like.

As mentioned above, preferred photoacid-labile groups of polymers of the invention include photoacid-labile ester or acetal groups, such as may be grafted onto -OH groups.

For instance, a haloacetate reagent such as *tert-*butyl chloroacetate (ClCH₂CO₂C(CH₃)₃) may be reacted with a hydroxy moiety such as a phenolic hydroxy. A carbonate reagent also may be reacted with a hydroxy moiety to provide pendant photoacid-labile esters, e.g. di-*tert*-butyl dicarbonate (O[CO₂C(CH₃)₂]₂) may be reacted with polymer hydroxy groups to provide pendent acid-labile ester groups. Reactions of such haloacetate or dicarbonate reagents may be suitably conducted under either acidic or basic conditions such as in the presence of potassium *t*-butoxide or N,N-dimethylaminopyridine. Basic reaction conditions are generally preferred.

A vinyl ether compound also suitably may be grafted onto a polymer hydroxy moiety to provide a photoacid-labile acetal group, e.g. a compound having at least one -(CH=CH)-O- groups such as ethylvinyl ether, t-amylvinyl ether, t-butylvinyl ether, vinylisobutyl vinyl ether, vinylpropyl ether, vinyl-2-ethylhexyl ether, vinyloctadecyl ether, and the like, as well as compounds that have two vinyl groups such as hydroxybutylvinyl ether, butanediol- 1,4-divinyl ether, cyclohexylvinyl ether, hexanedioldivinyl ether, and the like, as well as compounds having three vinyl groups such triethyleneglycol divinyl ether, diethyleneglycol monovinyl ether, and the like, as well as compounds having 4 or more vinyl groups such as 1,4-cyclohexanoldimethanoldivinyl ether, propenyl ether of propylene carbonate, 1,1,1-tris(vinyloxymethyl)ethane, cyclohexanedimethanolmonovinyl ether, and the like.

Suitably, to provide acetal photoacid-labile groups, such vinyl ether compounds may be grafted onto a hydroxy group (e.g. a phenolic group or alcohol group such as C₁-₁₂hydroxyalkyl) under acidic conditions preferably after dissolving the hydroxy-containing compound and the vinyl ether reagent in a suitable solvent such as one or more of acetone, tetrahydrofuran, diglyme and dioxane. Suitable acid catalysts to use to provide acidic conditions include hydrochloric acid, sulfuric acid, malonic acid and/or a sulfonic acid. Preferably, the molar ratio of free hydroxyl groups to the vinyl ether compound does not exceed 1 to 1, and more preferably the hydroxyl groups are present in a molar excess (e.g. 2:1) relative to the vinyl ether compound. In particular, a preferred synthesis includes grafting vinyl ether onto a preformed Si polymer having hydroxy groups, where only a portion of the polymer hydroxy groups are blocked with photoacid-labile groups and a portion of the polymer hydroxy groups remain unblocked as aqueous, alkaline developable groups.

Preferred repeat units that can contribute to aqueous developability of a photoresist containing the polymer include hydroxy, carboxy and other polar preferably acidic groups such as sulfonic acid and the like. For instance, a preferred repeat unit of this type is a hydroxy-containing unit, such as a phenolic unit, or an alcohol unit. However, for at least many preferred aspects of the invention, references herein to aqueous base-solubilizing groups or other similar term does not include a group containing a silanol moiety.

In such copolymers, units that are free of photoacid-labile and aqueous, alkaline developing groups will be free of moieties as discussed above, i.e. photoacid-labile ester or acetal moieties, or hydroxy, carboxy or sulfonic acid moieties. Preferred repeat units of this type include phenyl or alkyl groups that are not substituted with such photoacid-labile or aqueous, alkaline developing moieties; e.g. preferred repeat units of this type are alkyl (including cycloalkyl such as norbornyl) or phenyl groups that are either unsubstituted or substituted by one or more halo, unsubstituted alkyl, non-photoacid labile alkoxy, sulfonyl acid esters, and the like. Such substituents should be substantially stable (i.e. not undergoing a deblocking reaction) under typical lithographic conditions (e.g. pre-exposure thermal treatment of up to 140°C for 1-2 minutes; exposure; post-exposure thermal treatment of up to about 160°C for 1-2 minutes; and/or development with an aqueous, alkaline developer solution). Preferred substituents that are non-photoacid-labile and do not substantially promote aqueous developability useful for this type of repeat unit are disclosed as inert blocking groups in U.S. Patent 5,736,536 and 5,541,263 both to Thackeray et al. of the Shipley Company. As disclosed in those patents, suitable substituents that are substantially inert to lithographic processing and do not substantially increase aqueous, alkaline developability of a resist containing the polymer include alkoxy groups such as methoxy, ethoxy, propoxy, n-butoxy, sec-butoxy, etc.; alkyl esters represented by RCOO- where R is preferably an alkyl group having 1 to 6 carbon atoms such as methyl, ethyl, propyl, isopropyl, butyl, etc.; sulfonyl acid esters include both alkyl (e.g. C₁₋₆alkyl) are carbocyclic aryl esters such as methane sulfonyl, ethane sulfonyl, propane sulfonyl; benzene sulfonyl, and toluene sulfonyl esters, etc. All those groups can be grafted onto hydroxy groups as discussed above to form sulfonyl esters, e.g. by reaction of an alkylhalide such alkylchloride to form an alkoxy group, or an acid halide such as acid chloride to form an alkylester.

Such Si polymers containing two or three distinct repeat can be readily prepared. For instance, a hydroxy-Si reagent can be polymerized such as a hydroxylalkyl silyl reagent. A formed hydroxy-Si polymer can be functionalized to provide multiple distinct repeat units, e.g. pendant hydroxy groups can be reacted to have both photoacid-labile groups (such as by reaction of a dicarbonate or a halocetate ester as discussed above) and non-photoacid-labile groups such as provided by reaction of a sulfonyl acid or acid chloride or the like. Preferably, those distinct groups are reacted sequentially with the pre-formed hydroxy Si polymer, although it is possible to make both additions to the pre-formed polymer in a single reaction sequence. Preferably, a portion of the hydroxy moieties are left unreacted (i.e. unsubstituted) to provide aqueous, alkaline developing enhancing OH groups.

As mentioned above, preferred Si-polymers for use in a negative-acting resist composition will contain primary and secondary hydroxy moieties, suitably primary or second alcohol groups that may be present as hydroxyC₁₋₂₀alkyl groups. Such primary and secondary hydroxy can be effective sites or moieties for crosslinking.

Preferred polymers of the invention may be prepared as generally exemplified in Examples 1 through 4 which follow.

Thus, for instance, Example 3 below exemplifies preparation of a substituted sulfonamide silyl reagent (trihalide silyl reagent) through reaction of an unsaturated alkyl amine with a substituted sulfonyl chloride to form an unsaturated substituted sulfonamide. HSiCl₃ is then reacted across the carbon-carbon double bond of the formed unsaturated sulfonamide preferably in the presence of a metal catalyst such as a Pt catalyst and at elevated temperature, e.g. at reflux temperature of an aromatic solvent such as toluene or xylene. The formed trihalide silyl reagent then can be reacted with other silyl reagents to form Si-polymer with substituted sulfonamide groups, as exemplified in Example 3 below and discussed above.

A thiol silyl reagent (e.g. trihalide silyl reagent) can be formed by similar procedures. For instance, an unsaturated alkyl sulfide e.g. allyl mercaptancan be reacted with HSiCl₃ preferably in the presence of a metal catalyst such as a Pt catalyst and at elevated temperature, e.g. at reflux temperature of an aromatic solvent such as toluene or xylene. The trichlorosilyl reagent will add SiCl₃ to an unsaturated carbon. The formed trihalide silyl reagent then can be reacted with other silyl reagents to form Si-polymer with thio moieties.

As mentioned above, various groups of Si-compounds and Si-polymers may be optionally substituted, including groups of the above formulae (I), (II), (III) and (V). A group that is optionally substituted refers to the specified moiety that may be substituted at one or more available positions by one or more suitable groups such as, e.g., halogen such as fluoro, chloro, bromo and iodo; cyano; hydroxyl; nitro; azido; alkanoyl such as a C₁₋₆ alkanoyl group such as acyl and the like; carboxamido; alkyl groups including those groups having 1 to about 12 carbon atoms or from 1 to about 6 carbon atoms and more preferably 1-3 carbon atoms; alkenyl and alkynyl groups including groups having one or more unsaturated linkages and from 2 to about 12 carbon or from 2 to about 6 carbon atoms; alkoxy groups having those having one or more oxygen linkages and from 1 to about 12 carbon atoms or 1 to about 6 carbon atoms; aryloxy such as phenoxy; alkylthio groups including those moieties having one or more thioether linkages and from 1 to about 12 carbon atoms or from 1 to about 6 carbon atoms; alkylsulfinyl groups including those moieties having one or more sulfinyl linkages and from 1 to about 12 carbon atoms or from 1 to about 6 carbon atoms; alkylsulfonyl groups including those moieties having one or more sulfonyl linkages and from 1 to about 12 carbon atoms or from 1 to about 6 carbon atoms; and the like.

Photoimageable compositions of the invention are preferably used in multiple-layer systems, i.e. where the photoimageable composition is disposed over a further organic (polymer composition) layer that itself is disposed over a substrate surface such as a microelectronic wafer or device substrate or an optical waveguide substrate.

Preferred underlayer compositions include those that comprise a phenolic polymer such as a novolak and/or poly(vinylphenol). Also preferred is where the underlying polymer composition is a crosslinking composition, e.g. contain an acid or acid generator compound such as a thermal acid generator compound and preferably a separate crosslinker component such as an amine-based material, e.g. a melamine or benzoguanamine resin. For such crosslinking composition, the applied underlayer may be crosslinked prior to application of the overcoated photoimageable composition, e.g. by suitable thermal treatment such as heating at 140°C, 150°C, 160°C, 180°C, 200°C or 230°C for a time sufficient for crosslinking such as 0.5, 1 or 2 minutes. The underlying polymer composition is suitably non-photoimageable and does not contain a photoacid generator compound.

Suitably, more than one silicon-containing polymer may be used in the present photoimageable compositions. Thus, the present photoimageable compositions may include one, two or more silicon-containing polymers. When two or more silicon-containing polymers are used, at least one is a silicon-containing polymer of the present invention. The remaining silicon-containing polymers may be conventional silicon-containing polymers or polymers of the present invention. In this way, blends of polymers may be advantageously used in the present photoimageable compositions. Such blends include blends of the present silicon-containing polymers with non-silicon-containing polymers. In these blends, any ratio of polymers is suitable. The specific ratio will depend upon the particular polymers combined and the characteristics (dissolution rate, etch resistance, photospeed, etc.) desired and are within the ability of one skilled in the art.

A wide variety of photoactive components may be used in the present invention, including, but not limited to, photoacid generators and photobase generators. Photoacid generators are preferred. It will be appreciated by those skilled in that art that more than one photoactive component may be used advantageously in the photoimageable compositions of the present invention.

The photoacid generators useful in the present invention are any compounds which liberate acid upon exposure to activating radiation, e.g. sub-300 nm radiation such as 248 nm, or sub-200 nm radiation such as 193 nm or 157 nm. Suitable photoacid generators include e.g. imidosulfonaytes, onium salts, halogenated triazines, sulfonated esters and halogenated sulfonyloxy dicarboximides.

Preferred PAGs for imaging at 157 nm, 193 nm and 248 nm imaging include imidosulfonates such as compounds of the following formula: 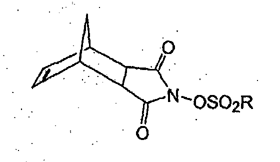 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonium and iodonium salts also suitable PAGs, particularly sulfonate salts. Two suitable agents for 193 nm and 248 nm imaging are the following PAGS 1 and 2:

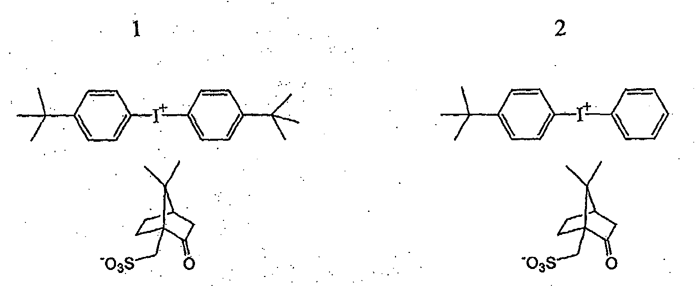

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

For imaging at 157 nm, a triphenyl sulfonium PAG is particularly preferred, complexed with anions such as the sulfonate anions mentioned above, particularly a perfluoroalkane sulfonate such as perfluorobutane sulfonate.

Particularly useful halogenated triazines include halomethyl-s-triazines. Suitable halogenated triazines include for example, 2-(1-(3,4-benzodioxolyl))-4,6-bis(trichloromethyl)-1,2,5-triazine, 2-(1-(2,3-benzodioxolyl))-4,6-bis(trichloromethyl)-1,3,5-triazine, 2-(1-(3,4-benzodioxolyl))-4,6-bis(tribromomethyl)-1,3,5-triazine, 2-(1-(2,3-benzodioxolyl))-4,6-bis(tribromomethyl)-1,3,5-triazine, and 2-(2-furfylethylidene)-4,6-bis(trichloromethyl)-1,3,5-triazine. Other triazine type photoacid generators useful in the present invention are disclosed in US Patent. No. 5,366,846, herein incorporated by reference.

Halogenated sulfonyloxy dicarboximides also will be useful as photoacid generators such as:
1-(((trifluoromethyl)sulfonyl)oxy)-1H-pyrrole-2,5-dione; N-((perfluorooctanesulfonyl)oxy)-5-norbomene-2,3-dicarboximide; N-((trifluoromethylsulfonyl)oxy)-5-norbomene-2,3-dicarboximide; 1-(((trifluoromethyl)sulfonyl)oxy)-2,5-pyrrolidinedione; 3a,4,7,7a-tetrahydro-2-(((trifluoromethyl)sulfonyl)oxy)-4,7-methano-1H-isoindole-1,3(2H)-dione; 2-(((trifluoromethyl)sulfonyl)oxy)-1H-benz(f)isoindole-1,3(2H)-dione; 3,4-dimethyl-1-(((trifluoromethyl)sulfonyl)oxy)-1H-pyrrole-2,5-dione; 2-(((trifluoromethyl)sulfonyl)oxy)-1H-isoindole-1,3(2H)-dione; and 2-(((trifluoromethyl)sulfonyl)oxy)-1H-benz(de)isoquinoline-1,3(2H)-dione.

In positive-acting systems of the present invention, the photoactive components are typically added to photoimageable compositions in an amount sufficient to generate a latent image in a coating layer of resist material upon exposure to activating radiation. When the photoactive component is a photoacid generator, the amount is typically in the range of 0.1 to 15 percent by weight, based on the weight of the resin, and preferably 1 to 8 percent by weight.

In negative-acting systems of the present invention, the amount of photoactive component useful is any amount sufficient to catalyze cross-linking of the silicon-containing polymer or oligomer. The photoactive components are typically used in the range of 0.1 to 25% by weight, based on the weight of the composition. It is preferred that the photoactive component is present in an amount in the range of 0.1 to 15% by weight, more preferably in the range of 0.1 to 12% by weight, and still more preferably less than or equal to 5% by weight. A particularly suitable range is from 0.1 to 5% by weight.

Negative-acting resist preferably include one or more cross-linking agents. Any aromatic or aliphatic cross-linking agent that reacts with the silicon-containing polymer or oligomer is suitable for use in the present invention. Such organic cross-linking agents will cure to form a polymerized network with the silicon-containing polymer or oligomer, and reduce solubility in selected solvents. Such organic cross-linking agents may be monomers or polymers. It will be appreciated by those skilled in the art that combinations of cross-linking agents may be used successfully in the present invention.

Suitable organic cross-linking agents useful in the present invention include, but are not limited to: amine containing compounds, epoxy containing materials, compounds containing at least two vinyl ether groups, allyl substituted aromatic compounds, and combinations thereof. Preferred cross-linking agents include amine containing compounds and epoxy containing materials.

The amine containing compounds useful as cross-linking agents in the present invention include, but are not limited to: a melamine monomers, melamine polymers, alkylolmethyl melamines, benzoguanamine resins, benzoguanamine-formaldehyde resins, urea-formaldehyde resins, glycoluril-formaldehyde resins, and combinations thereof. These resins may be prepared by the reaction of acrylamide or methacrylamide copolymers with formaldehyde in an alcohol-containing solution, or alternatively by the copolymerization of N-alkoxymethylacrylamide or methacrylamide with other suitable monomers. Particularly suitable amine-based crosslinkers include the melamines manufactured by Cytec of West Paterson, New Jersey, such as CYMEL™ 300, 301, 303, 350, 370, 380, 1116 and 1130; benzoguanamine resins such as CYMEL™ 1123 and 1125; the glycoluril resins CYMEL™ 1170, 1171 and 1172; and the urea-based resins BEETLE™ 60, 65 and 80, also available from Cytec, West Paterson, New Jersey. A large number of similar amine-based compounds are commercially available from various suppliers.

Melamines are the preferred amine-based cross-linkers. Particularly preferred are alkylolmethyl melamine resins. These resins are typically ethers such as trialkylolmethyl melamine and hexaalkylolmethyl melamine. The alkyl group may have from 1 to 8 or more carbon atoms but is preferably methyl. Depending upon the reaction conditions and the concentration of formaldehyde, the methyl ethers may react with each other to form more complex units.

Particularly suitable amine-based cross-linking agents include those of the following formula: 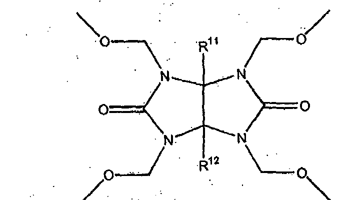 wherein R¹¹ and R¹² are independently selected from H, (C₁-C₆)alkyl and phenyl. Preferred alkyl groups for R¹¹ and R¹² are methyl and propyl.

Epoxy containing materials useful as cross-linkers in the present invention are any organic compounds having one or more oxirane rings that are polymerizable by ring opening. Such materials, broadly called epoxides, include, but are not limited to: monomeric epoxy compounds, and polymeric epoxides that may be aliphatic, cycloaliphatic, aromatic or heterocyclic. Preferred epoxy cross-linking materials generally, on average, have at least 2 polymerizable epoxy groups per molecule. The polymeric epoxides include linear polymers having terminal epoxy groups (e.g., diglycidyl ether of a polyoxyalkylene glycol), polymers having skeletal oxirane units (e.g., polybutadiene polyepoxide), and polymers having pendant epoxy groups (e.g., glycidyl methacrylate polymer of copolymer). The epoxides may be pure compounds but are generally mixtures containing one, two or more epoxy groups per molecule.

Useful epoxy-containing materials may vary from low molecular weight monomeric materials and oligomers to relatively high molecular weight polymers and may vary greatly in the nature of their backbone and substituent groups. For example, the backbone may be of any type and substituent groups may be any group free of any substituents reactive with an oxirane ring at room temperature. Suitable substituents include, but are not limited to: halogens, ester groups, ethers, sulfonate groups, siloxane groups, nitro groups, phosphate groups, and the like. Particularly useful epoxy containing materials in the present invention include glycidyl ethers. Examples are the glycidyl ethers of polyhydric phenols obtained by reacting a polyhydric phenol with an excess of chlorohydrin such as epichlorohydrin (e.g., the diglycidyl ether of 2,2-bis-(2,3-epoxypropoxyphenol)propane). Such glycidyl ethers include bisphenol A epoxides, such as bisphenol A ethoxylated diepoxide. Further examples of epoxides of this type are described in U.S. Pat. No. 3,018,262, herein incorporated herein by reference to the extent this patent teaches the preparation of such epoxides.

The compositions of the present invention may suitably comprise only a single type of organic cross-linker, e.g., only an amine containing cross-linker, or may contain two or more different cross-linkers. When a combination of organic cross-linkers is used in the present invention, it is preferred that the combination include an amine containing compound and an epoxy containing compound. The concentration of organic cross-linking agents in the compositions of the present invention may vary within a relatively wide range. It will be appreciated by those skilled in the art that suitable organic cross-linker concentrations will vary with factors such as cross-linker reactivity and specific application of the composition. Typically, the cross-linking agent(s) is present in an amount in the range of 0.1 to 80% by weight, based on the total weight of the composition, preferably in the range of 0.5 to 50%, and more preferably in the range of 1 to 25%. It is preferred that a cross-linking agent is used in the compositions of the present invention.

The photoimageable compositions of the present invention may optionally further include one or more additional components, including, but not limited to, solvents, anti-striation agents, plasticizers, surfactants, base additives, speed enhancers, fillers, dyes and the like. In positive-acting systems, a base additive is typically used to adjust the photospeed of the composition. Such optional additives will be present in relatively minor concentrations in a photoresist composition except for fillers and dyes which may be used in relatively large concentrations, e. g. in amounts of from about 5 to 30 percent by weight, based on the total weight of the composition's dry components.

The photoimageable compositions of the present invention may be readily prepared by those skilled in the art. For example, a photoresist composition of the invention can be prepared by dissolving the components of the photoresist, i.e. polymer binder and photoactive component, in a suitable solvent. Such suitable solvents include, but are not limited to: ethyl lactate, ethylene glycol monomethyl ether, ethylene glycol monomethyl ether acetate, propylene glycol monomethyl ether, propylene glycol monomethyl ether acetate, 3-ethoxyethyl propionate, 2-heptanone, γ-butyrolactone, and mixtures thereof.

Typically, the solids content of the photoresist composition varies from about 5 to about 35 percent by weight, based on the total weight of the composition. The resin binder and photoactive components should be present in amounts sufficient to provide a film coating layer and formation of good quality latent and relief images.

Such photoresist compositions may be applied to a substrate by any known means, such as spinning, dipping, roller coating and the like. When the compositions are applied by spin coating, the solids content of the coating solution can be adjusted to provide a desired film thickness based upon the specific spinning equipment utilized, the viscosity of the solution, the speed of the spinner and the amount of time allowed for spinning.

As discussed above, the present photoimageable compositions are particularly suitable for use as a top layer in a bilayer photoresist system. As also discussed above, in such a system, a bottom layer of a conventional photoresist, such as novolac polymer based resist, inert polyarylether-sulfone copolymer based resist or a novolac or polyhydroxystyrene-based thermally cross-linkable system. Such bottom layer is typically applied to or coated on a substrate using any of the above described procedures. The bottom layer is then hard baked such as at 230° C for 2 minutes, after which the present photoimageable compositions are coated on the cured bottom layer. The bottom layers preferably contain an amount of a UV absorbing component, such as an anthracene dye, sufficient for optical density and etch performance. The bottom layers typically have a thickness of from 0.4 to 1 µm. The top layer of the present photoimageable compositions is typically from 0.05 to 1 µm thick, preferably from 0.1 to 0.5 µm, and more preferably from 0.1 to 0.3 µm.

After being coated on the bottom layer, the present photoimageable composition top layer is dried by heating (baked) to remove any solvent. It is preferably dried until the coating is tack free. Thereafter, it is imaged through a mask in a conventional manner. The exposure is sufficient to effectively activate the photoactive component of the photoresist to produce a patterned image in the resist coating layer, and more specifically, the exposure energy typically ranges from about 1 to 100 mJ/cm², dependent upon the exposure tool and the components of the photoresist composition.

The photoimageable compositions of the present invention may be activated by a variety of exposure wavelengths, such as 248,193,157 nm and 11-15 nm. However, the photoimageable compositions of the present invention may be used with other radiation sources, such as, but not limited to, visible, e-beam, ion-beam and x-ray.

Following exposure, the film top layer of the composition is preferably baked at temperatures ranging from about 70° C to 160° C. Thereafter, the top layer film is developed to form an etch pattern. The exposed resist film is rendered positive working by employing a polar developer, preferably an aqueous based developer, such as quaternary ammonium hydroxide solutions, such as tetra-alkyl ammonium hydroxide, preferably a 0.15 to 0.26 N tetramethylammonium hydroxide; various amine solutions, such as ethylamine, n-propylamine, diethylamine, triethylamine or methyl diethylamine; alcohol amines, such as diethanolamine, triethanolamine; cyclic amines, such as pyrrole, pyridine, and the like. One skilled in the art will appreciate which development procedures should be used for a given system.

The pattern is next transferred to the underlayer or bottom layer by etching, such as with an oxygen reactive ion etch process. After such processing, the resists, both top and bottom layers, may be removed from the processed substrate using any stripping procedures known in the art.

The present photoimageable compositions are useful in all applications where photoresists are typically used. For example, the compositions may be applied over silicon wafers or silicon wafers coated with silicon dioxide for the production of microprocessors and other integrated circuit components. Aluminum-aluminum oxide, gallium arsenide, ceramic, quartz, copper, glass, spin-on organic dielectrics, spin-on or chemical vapor deposited inorganic dielectrics, and the like are also suitable employed as substrates for the photoresist compsitions of the invention. Other chemical vapor deposited layers, such as cap layers, etch stops and the like, may also be used as substrates.

Alternatively, the present compositions may also be used in optoelectronics applications, such as in the manufacture of optical waveguides. By "optical waveguide" is meant any device that transmits optical radiation across a two-dimensional substrate surface. Suitable optical waveguides include, but are not limited to, splitters, couplers, spectral filters, polarizers, isolators, wavelength division multiplexing structures, and the like. Such waveguides may also contain active functionality, such as amplification and switching such as with electro-optic, thermo-optic or acousto-optic devices. To be useful as amplifiers, the present waveguides typically contain one or more dopants. Erbium is an exemplary dopant. Such dopants are well known in the art. Thus, the present waveguides suitable for use as amplifiers contain one or more dopants.

The waveguides of the present invention may be manufactured as individual waveguides or as an array of waveguides. Whether such waveguides are prepared as an array depends on the particular use and is within the ability of one skilled in the art.

In one embodiment, optical waveguides may be prepared by first disposing a layer of the present compositions on a substrate by any means including, but not limited to, screen coating (or screen printing), curtain coating, roller coating, slot coating, spin coating, flood coating, electrostatic spray; spray coating, dip coating or as a dry film. When the compositions of the present invention are spray coated, a heated spray gun may optionally be used. The viscosity of the composition may be adjusted to meet the requirements for each method of application by viscosity modifiers, thixotropic agents, fillers and the like, Any substrate suitable for supporting a waveguide may be used with the present compositions. Suitable substrates include, but are not limited to, substrates used in the manufacture of electronic devices such as printed wiring boards and integrated circuits. Particularly suitable substrates include laminate surfaces and copper surfaces of copper clad boards, printed wiring board inner layers and outer layers, wafers used in the manufacture of integrated circuits, liquid crystal display ("LCD") glass substrates and the like.

The coated substrate is typically then cured, such as by baking, to remove any solvent. Such curing may be a variety of temperatures, depending upon the particular solvent chosen. Suitable temperatures are any that are sufficient to substantially remove any solvent present. Typically, the curing may be at any temperature from room temperature (i.e., 25° C) to 170° C. Such curing typically occurs over a period of from 5 seconds to 30 minutes. Such curing may be affected by heating the substrate in an oven or on a hot plate.

After curing, the layer of the present composition disposed on the substrate is then imaged by exposure to actinic radiation through appropriate artwork or a mask. Following exposure, the composition is then cured at a temperature of from 40° to 170° C. Curing time may vary but is generally from about 30 seconds to about 1 hour. While not intending to be bound by theory, it is believed that upon exposure to actinic radiation the silsesquioxane oligomer cross-links, particularly with the optional cross-linking agent. The exposed areas are rendered less soluble than the unexposed areas. Thus, the unexposed areas may be removed, such as by contact with a suitable solvent, aqueous developer or solvent-water mixture, leaving only the exposed areas remaining on the substrate. Suitable aqueous developers include alkali metal hydroxides such as sodium hydroxide and potassium hydroxide in water as well as tetraalkylammonium hydroxide in water. Such developers are typically used in concentrations from 0.1 to 0.3 N, such as 0.15 to 0.26 N tetramethylammonium hydroxide in water. The choice of developer is well within the ability of those skilled in the art. Such development may be at a variety of temperatures such as from room temperature to about 100° C. The time of such development depends upon the material to be removed and the temperature used, but is generally from about 10 seconds to about 1 hour.

Following development, the present waveguides may undergo a final cure step, or re-flow step. In such final cure step, the waveguides may be heated at a temperature in from about 130° to 225° C in air or inert atmospheres such as nitrogen or argon. Such final cure step aids in removal of residual solvent, removal of hydroxyl groups from the silsesquioxane polymer such as by increasing the extent of cross-linking, alter the waveguide profile such as to reduce surface roughness, and improves the optical transmission properties of the material.

Optical waveguides typically have a core and a cladding, wherein the cladding has a lower index of refraction as compared to the core. Particularly useful waveguides have core having an index of refraction of from 1.4 to 1.55. Typically, suitable cladding has an index of refraction of from 1.3 to 1.54.

It is preferred that a cladding layer is first deposited on a substrate. If the cladding layer is photocurable or thermocurable, it may be blanket cured as a first step. The photodefinable core material is then deposited on the cladding layer, imaged and the unexposed areas optionally removed. A second cladding layer is then deposited on the imaged waveguide. The second cladding layer may be the same or different from the first cladding layer. However, the indices of refraction of the first and second cladding layers should be the same. The second cladding layer is then cured, or imaged in the case of a photocurable cladding composition, to provide a waveguide structure.

The Si oligomers and polymers of the present invention are suitable for use in the cladding and/or core of the present optical waveguides. Preferably, the present photodefinable compositions are used to prepare cores for optical waveguides. It will be appreciated that the refractive index of a photodefinable composition including a present Si oligomer and one or more organic cross-linking agents may be modified by changing the amount and type of the one or more cross-linking agents selected and/or photoactive component Thus, the present compositions may be useful as core or cladding material depending upon the type and quantity of cross-linking agents selected.

In an alternate embodiment, the present compositions may be used to make porous optoelectronic devices, such as porous core and/or cladding materials in waveguides. Such porous optoelectronic devices may be prepared according to the same methods used to prepare porous dielectric materials.

All documents mentioned herein are incorporated herein by reference. The following non-limiting examples are illustrative of the invention.

### Example 1: Polymer synthesis.

The following polymer was prepared as shown in the following Scheme.

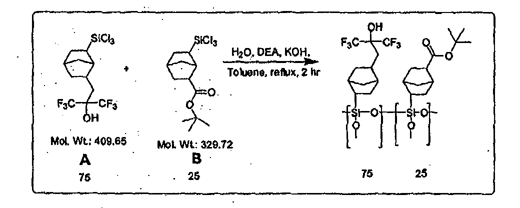

A reaction vessel was charged as follows:

| | |
|---|---|
| Monomer A | 15.36 g (0.0375 mol) |
| Monomer B | 4.11 g (0.0125 mol) |
| Toluene | 40 g (46 ml) |
| DI Water | 16.8 g |
| Diethylamine | 10.97 g (15.5 ml) |
| KOH | 0.21 g |

More specifically, to a 250 ml 3 necked round-bottom flask fitted with a thermometer and an addition funnel, gas inlet was added the solution of DEA (11 g), DI water (16.8g) and toluene (10 ml). The flask temperature was between 0 to -5°C. To this chilled solution was added a mixture of the monomers (A and B as specified immediately above) and toluene (40 g) drop wise over a period of 55 min. (Note: at 0°C, there were two phases: a milky white bottom layer and a clear toluene top layer). After the addition was complete the whole mixture was allowed to come to RT and stirred for additional 1.5 hr. The two layers were separated by addition of extra water to dissolve the quaternary ammonium salt (observation: apart from the two layers, an oily white material was found in the flask which was not soluble in water as well as in toluene at room temperature. However the oily materials dissolved completely in toluene when it was heated to 50°C.) The toluene layer was washed with DI water (3 x 1500 ml). The pH was still around 9. It was further washed with 10% acetic acid (1x 50 ml) and further washed with DI water to bring the pH to 7.

The toluene layer from above work-up was added into a 250 ml 3 necked RB flask (total solution was ∼ 200 ml) fitted with a thermometer, Dean-Stark trap and a condenser. To the total solution was added 0.21 g of KOH dissolved in 1 ml DI water followed by 1.0 ml of DI water rinse. The mixture was heated to reflux to azeotrope water that was added to the reaction and formed during condensation. The reflux was continued for 2 hr (Note: during reflux, removed toluene (10 mL)/water (3 mL) mixture from the Dean Stark condenser). After 2hr reflux, the solution was brought into RT and washed with 20 % acetic acid (2 x 50ml) further with DI water until the pH = 7. The toluene solution was washed with ion-exchange resin (IRN-150) for 2 hr. Filtered the resins and toluene was removed and the polymer was dried at 50°C overnight. The final polymer was analyzed by various techniques such as: ¹H, ¹³C and ²⁹Si NMR, GPC-PDA, DSC, TGA, Base content, FT-IR,MALDI-TOF.

The number of OH (silanol) group per silicon atom was calculated by using ²⁹Si NMR and was found to be found to be 0.2.

### Example 2. Preparation of Polymer B

Experimental procedure for the preparation of soluble polysilsesquioxane using Template method is as follows: 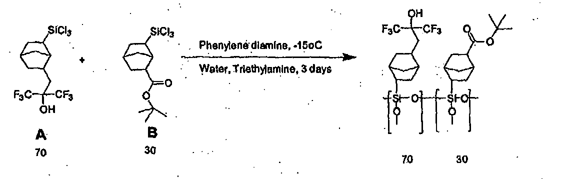 A reaction vessel was charged as follows:

| | |
|---|---|
| Monomer A | 10.4 g (0.036 mol) |
| Monomer B | 34.0 g (0.084 mol) |
| Phenylenediamine | 6.9 g |
| Triethylamine | 36 mL |
| Tetrahydrofuran | 260 mL |
| Toluene | 150 mL |
| DI Water | 4.3 mL |

A solution of 6.9 g of 1,4-phenylenediamine, 12 ml of triethylamine and 160 ml of THF was added drop wise to a three necked flask containing 10.4 g of monomer A and 34.0 g of monomer B in 150 ml of toluene at-15°C. This solution was stirred for 30 min at low temperature (-15°C) after which 4. 3 ml of water and 24 ml of triethylamine and 100 ml of THF were added drop wise to the flask at -5°C. This mixture was stirred at this temperature for additional 3 h then washed with water until neutral and dried with anhydrous sodium sulfate overnight. The final solution from the above reaction was stirred in the presence of molecular sieves (4A) and a 1 ml of triethylamine at 50°C for 72 h. After 72 h, the polymer solution was washed with water until neutral and the solvent was distilled off. The solid polymer was dissolved in minimum amount of THF and precipitated in water (twice) and dried in vacuum at 50°C for 24 h. The final polymer was analyzed by various techniques such as: ¹H, ¹³C and ²⁹Si NMR, GPC-PDA, DSC, TGA, Base content, FT-IR, MALDI-TOF.

### Example 3: Polymer containing sulfonamide units:

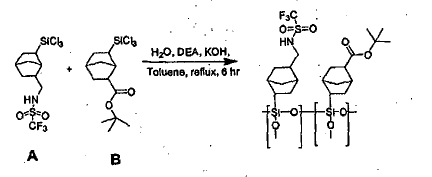

### Synthesis of Monomer A:

All reaction glassware was dried in the oven overnight at 100°C. The glassware was set up and cooled under a stream of nitrogen. The reaction was carried out under a blanket of nitrogen.

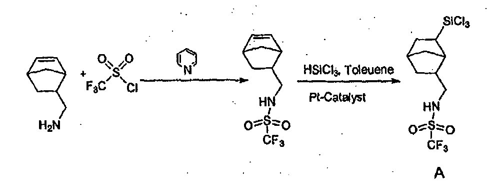

Into a dry 250 ml 3 necked flask quipped with a magnetic stirrer, condenser and an addition funnel was added 80 ml dry tetrahydrofuran, 9.7 g of pyridine and 12.3 g of Norbomene amine. The reaction mixture was cooled to 0oC and 16.9 g of trifluoromethanesulfonylchloride was added to this mixture and stirred for 4 h. After stirring for 4 h, the pyridinium salt was filtered off and the THF was evaporated to dryness. The resulting solid was dissolved in diethylether and washed with 3.5 % HCl followed by deionized water till the pH 7. The ether was dried over sodium sulphate and evaporated the solvent to get an oily product. The product was analyzed by 1H, 13C and 19F NMR and it was further hydrosilylated by the following procedure:

A 100 ml 2 necked round bottomed flask quipped with refluxing condenser and an addition funnel flushed with nitrogen for 10 min and charged 200 mg of platinum-divinyltetramethyldisiloxane complex and 25 ml of toluene. The mixture was stirred at room temperature. 10.0g of the above mixture was added (all at once) to this clear solution followed by the drop wise addition of 20 g of trichlorosilane (total addition time ~10 min) at room temperature. The whole mixture was stirred at 50°C for 48 h, after which the solvent and the unreacted starting materials were distilled off. The crude product was subjected to ¹H and ¹³C NMR (yield >95%).

### Polycondensation reaction:

To a 250 ml 3 necked Rb flask fitted with a thermometer and an addition funnel, gas inlet was added the solution of DEA (11 g), DI water (16.8g) and toluene (10 ml). The flask temperature was between 0 to -5°C. To this chill solution was added a mixture of the monomers (A and B) and toluene (40 drop wise over a period of 55 min. (Note: at 0°C, there were two phases: a milky white bottom layer and a clear toluene top layer). After the addition was complete the whole mixture was allowed to come to RT and stirred for additional 1.5 hr. The two layers were separated by addition of extra water to dissolve the quaternary ammonium salt (Observation: apart from the two layers, an oily white material was found in the flask which was not soluble in water as well as in toluene at room temperature. However the oily materials dissolved completely in toluene when it was heated to 50°C. The toluene layer was washed with DI water (3 x 1500 ml). The pH was still around 9. It was further washed with 10% acetic acid (1x 50 ml) and further washed with DI water to bring the pH to 7.

The toluene layer from above work-up was added into a 250 ml 3-necked RB flask (total solution was ~ 200 ml) fitted with a thermometer, Dean-Stark trap and a condenser. To the total solution was added 0.21 g of KOH dissolved in 1 ml DI water followed by 1.0 ml of DI water rinse. The mixture was heated to reflux to azeotrope water that was added to the reaction and formed during condensation. The reflux was continued for 2 hr (Note: during reflux, removed toluene (10 mL) /water (3 mL) mixture from the Dean Stark condenser). After 2hr reflux, the solution was brought into RT and washed with 20 % acetic acid (2 x 50ml) further with DI water until the pH = 7. The toluene solution was washed with ion-exchange resin (IRN-150) for 2 hr. Filtered the resins and toluene was removed and the polymer was dried at 50°C overnight.

### Example 4: Polymer particularly suitable for negative bilayer application:

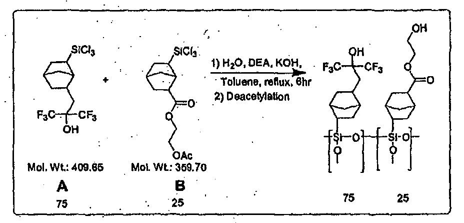

### Monomer A Synthesis

| Material | Amt (g) | Amt (ml) | Moles | Source |
|---|---|---|---|---|
| 3-(5-bicyclo[2.2.1]hepten-2-yl)- | 50 | | 0.182 | Central Glass |
| 1,1,1-trifluoro-2- | | | | |
| (trifluoromethyl)propan-2-ol | | | | |
| Trichlorosilane | 100 | ~75 | 0.738 | Gelest |
| Toluene | | 175 | | |
| Pt(divinyltetramethyl) disiloxane | | 5 drops | | |
| complex | | | | |

All reaction glassware was dried in the oven overnight at 100C. The glassware was set up and cooled under a stream of nitrogen. The reaction was carried out under a blanket of nitrogen.

To a 500ml 3N-RB flask fitted with a gas inlet, thermometer, overhead stirrer, condenser and a glass stopper was added 50g 3-(5-bicyclo[2.2.1]hepten-2-yl)-1,1,1-trifluoro-2-(trifluoromethyl)propan-2-ol 100ml of toluene and the catalyst. To this solution was added the trichlorosilane followed by the remainder of the toluene (75ml). The mixture was heated to 50-51C using a heating mantel. The reaction was held at 50-51°C for 36 hours. The reaction was cooled to room temperature and the excess trichlororsilane and toluene were removed under reduced pressure leaving 67g of a crude oil. The product was purified by high vacuum distillation to give 63.3g of product (74C/<1mm).

### Monomer B was also prepared by the same procedure.

### Polycondensation Reaction:

| Charge | |
|---|---|
| A | 19.88 g (0.04852 mole) |
| B | 5.99 g (0.01665 mole) |
| Toluene | 60 ml |
| Acetone | 5 ml |
| DI Water | 34 g |
| Diethylamine | 22 g; KOH: 0.4 g in 3 ml water |

To a 250 ml 3 necked Rb flask fitted with a thermometer and an addition funnel, gas inlet was added the solution of DEA (22 g), DI water (34 g) and toluene (10 ml). The flask temperature was between 0 to -5°C. To this chilled solution was added a mixture of the monomers (A and B) and toluene (50 g) drop wise over a period of 55 min. (Note: at 0°C, there were two phases: a milky white bottom layer and a clear toluene top layer). After the addition was complete the whole mixture was allowed to come to RT and stirred for additional 1.5 hr. The two layers were separated by addition of extra water to dissolve the quart. ammo Salt The toluene layer was washed with DI water (3 x 1500 ml). The pH was still around 9. It was further washed with 10% acetic acid (1x 50 ml) and further washed with DI water to bring the pH to 7.

The toluene layer from above work-up was added into a 250 ml 3 necked RB flask (total solution was ~ 175 ml) fitted with a thermometer, Dean-Stark trap and a condenser. To the total solution was added 0.4 g of KOH dissolved in 2 ml DI water followed by 1.0 ml of DI water rinse. The mixture was heated to reflux to azeotrope water that was added to the reaction and formed during condensation. The reflux was continued for 4 hr (Note: during reflux, removed toluene /water mixture from the Dean Stark condenser). After 4hr reflux, the solution was brought into RT and washed with 20 % acetic acid (2 x 50ml) further with DI water until the pH = 7. The toluene solution was washed with ion-exchange resin (IRN-150) for 2 hr. Filtered the resins and toluene was removed and the polymer was dried at 50°C overnight. The deprotection of acetyl group from one of the monomers was carried by refluxing the copolymer in presence of dilute ammonium hydroxide solution for 24 hr. The final polymer was characterized by ¹H, ¹³C and ²⁹Si NMR, GPC-PDA, DSC, TGA, Base content, FT-IR, MALDI-TOF MS.

| NBTFE silane monomer Synthesis | | | | |
|---|---|---|---|---|
| Material | Amt (g) | Amt (ml) | Moles | Source |
| 1-Bicyclo[2.2.1]hept 5-en- | 22 | | 0.114 | JM-4000- |
| 2-yl | | | | 61 |
| - 2,2,2-trifluoro-ethanol | | | | |
| Trichlorosilane | 50 | ~36.5 | 0.368 | Gelest |
| Toluene | | 75 | | |
| Pt(divinyltetramethyl) | 0.15 | | | |
| disiloxane complex | | | | |

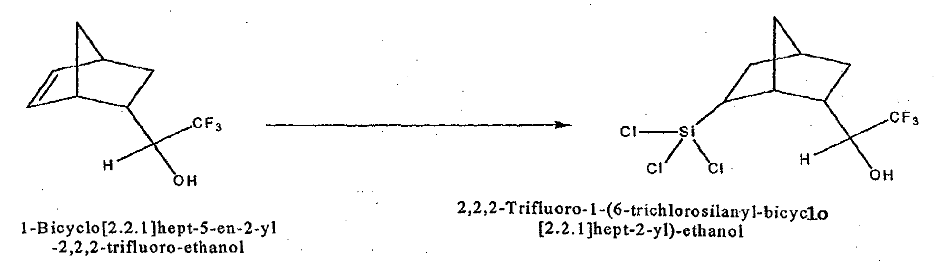

All reaction glassware was dried in the oven overnight at 100°C. The glassware was set up and cooled under a stream of nitrogen. The reaction was carried out under a blanket of nitrogen.

To a 300ml 3N-RB flask fitted with a gas inlet, thermometer, overhead stirrer, condenser and a glass stopper was added 22g 1-Bicyclo[2.2.1]hept-5-en-2-yl-2,2,2-trifluoro-ethanol, 75ml of toluene and the catalyst. To this solution was added the trichlorosilane. The mixture was heated to 50-51C using a heating mantel. The reaction was held at 50-5 1 C for 72 hours. The reaction was cooled to room temperature and the excess trichlororsilane and toluene were removed under reduced pressure leaving 34g of a crude oil. NMR indicated all the staring material was consumed. Theoretical yield - 37.3

### Example 5: Photoresist preparation and lithographic processing.

A photoresist composition was prepared as follows. A homogeneous resist solution was obtained by mixing 94.86 parts of the Si polymer prepared in Example 1, 4.50 parts of triphenylsulfonium perfluorobutanesulfonate, 0.54 parts of Troeger's base and 0.1 parts of a surfactant with 660 parts of 2-heptanone. The thus prepared resist formulation was filtered through a 0.10µm Teflon filter and applied by spin coating to a thickness of 1000 ± 15Å onto a phenolic underlayer composition layer. The applied photoresist coating layer was soft baking at 120°C for 60 seconds. The underlayer composition layer had been applied by spin coating onto a silicon wafer to a thickness of 5100 Å using a 60 second bake at 250°C.

The applied resist layer was exposed to 193 nm radiation using an ISI Microstepper (0.60NA, 0.70σ) through a binary photomask using conventional illumination. Wafers were subjected to a post-exposure bake at 120°C for 60 seconds and subsequently developed in LDD-26W developer using a 60 second single puddle process without pre-wetting. As a result, a resist pattern exhibiting 120nm 1:1 trenches on was obtained.

### Example 6: Photoresist preparation from Polymer B and lithographic processing.

A photoresist composition was prepared as follows. A homogeneous resist solution was obtained by mixing 94.86 parts of the Si polymer prepared in Example 2, 4.50 parts of triphenylsulfonium perfluorobutanesulfonate, 0.54 parts of Troeger's base and 0.1 parts of a surfactant with 660 parts of 2-heptanone. The thus prepared resist formulation was filtered through a 0.10m Teflon filter and applied by spin coating to a thickness of 1000 ± 15Å onto a phenolic underlayer composition layer. The applied photoresist coating layer was soft baking at 120°C for 60 seconds. The underlayer composition layer had been applied by spin coating onto a silicon wafer to a thickness of 5100 Å using a 60 second bake at 250°C.

The applied resist layer was exposed to 193 nm radiation using an ISI Microstepper (0.60NA, 0.70σ) through a binary photomask using conventional illumination. Wafers were subjected to a post-exposure bake at 120°C for 60 seconds and subsequently developed in LDD-26W developer using a 60 second single puddle process without pre-wetting. As a result, a resist prepared from polymer B exhibited no imaging as the resist film was washed off of the wafer. This was attributed to the high silanol content (0.8 Si-OH/Si) in combination with high hexafluoro alcohol content (70 mol%).

### Example 7: Dissolution rate studies.

Polymers have the molar ratio of the respective units A and B as shown below (including Table 1) were coated to approximately equal dried (soft bake) coating layers over a wafer substrate. F:Si ratios of those polymers also are shown in Table 1.

Dissolution rates were measured of those polymer coating layers with a 0.26 N alkaline aqueous developer. Dissolution rates are set forth in Table 1.

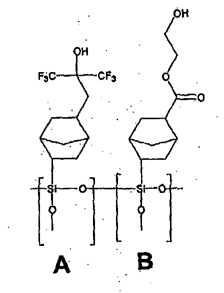

**Table 1**

| **Polymer Composition (molar ratio of units A:B shown above)** | **Mn** | **PDI** | **DR (A°/Sec) 0.26 N aqueous alkaline developer** | **F/Si ratio** |
|---|---|---|---|---|
| 50/50 | 2813 | 1.09 | 0 | 2.03 |
| 75/25 | 3419 | 1.15 | 270 | 3.04 |
| 90/10 | 2759 | 1.11 | 1750 | 3.65 |

### Example 8: Etch resistance studies.

Coating layers that contained polymers of differing F:Si ratios were analyzed for plasma etch rates. Results are shown in Figure 1.

The foregoing description of the invention is merely illustrative thereof, and it is understood that variations and modifications can be made as set forth in the following claims.

## Claims

1. A photoimageable composition comprising a photoactive component and a polymer component,
the polymer component comprising a fluorinated polymer that comprises Si atoms and silanol groups,
wherein the polymer has a ratio of fluorine atoms to Si atoms of about 3 or less.

2. The photoimageable composition of claim 1 wherein the polymer has a ratio of fluorine atoms to silicon atoms of about 2 or less.

3. The photoimageable composition of claim 1 wherein the polymer comprises at least three distinct repeat units.

4. The photoimageable composition of claim 3 wherein at least two of the distinct repeat units have differing numbers of fluorine atoms.

5. The photoimageable composition of claim 3 wherein at least two of the distinct repeat units have differing numbers of silicon atoms.

6. The photoimageable composition of claim 1 wherein the polymer comprises photoacid-labile groups.

7. The photoimageable composition of claim 1 wherein the composition is a negative-acting photoresist.

8. The photoimageable composition of claim 1 wherein the polymer is substantially free of aromatic groups.

9. A coated substrate comprising:
a) a polymer composition coating layer applied over a substrate surface;
b) a coating layer of a photoimageable composition of claim 1 disposed over the polymer composition coating layer.

10. A method for forming a electronic device, comprising:
(a) applying on a substrate a coating layer of an organic polymer composition;
(b) over the polymer composition coating layer, applying a photoimageable composition of claim 1;
(c) exposing the photoimageable composition coating layer to activating radiation and developing the exposed photoimageable layer.
